# EUROPEAN PATENT SPECIFICATION

(11) **EP 0 426 105 B1**
(45) Date of publication and mention of the grant of the patent: **20.07.1994**
(21) Application number: 90120789.4
(22) Date of filing: 30.10.1990
(51) Int. Cl.: C23C 16/44, C23C 16/34

(54) **Chemical vapor growth apparatus**
Chemischer Dampfablagerungsapparat
Dispositif de déposition en phase vapeur

(30) Priority: 30.10.1989 JP 279976/89
(43) Date of publication of application: 08.05.1991
(73) Proprietor: KABUSHIKI KAISHA TOSHIBA, Kawasaki-shi, Kanagawa-ken 210 (JP)
(72) Inventor: Miyazaki, Shinji, Yokohama-shi, Kanagawa-ken (JP)
(74) Representative: Ritter und Edler von Fischern, Bernhard,Dipl.-Ing.

(56) References cited:
- GB-A- 2 008 084
- PATENT ABSTRACTTS OF JAPAN, vol. 13, no. 238 (C-603)[3586], 5th June 1989; & JP-A-1 47 872

## Description

The present invention relates to a chemical vapor growth apparatus.

According to the prior art document GB-A-2 008 084 a conventioanal chemical vapor growth apparatus comprises a process chamber for carrying out a chemical vapor growth process, gas flow rate control means for mainly supplying gases to the process chamber, exhaust means for exhausting the gases remaining in the gas flow rate control means and provided at a portion thereof, and gas process means for removing the gases.

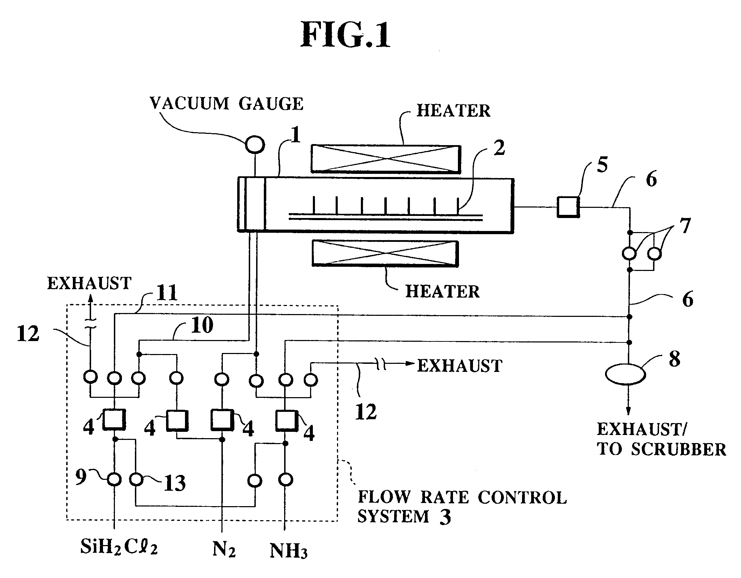

Another conventional chemical vapor growth apparatus apparatus is illustrated in Fig. 1 of the drawings showing a schematic diagram of a chemical vapor growth apparatus of a semiconductor device.

The chemical vapor growth apparatus comprises a reaction tube 1, a flow rate control system 3 for supplying reactive gases in respectively predetermined amounts to the reaction tube 1 as a process chamber, a gas trap 5 connected to the outlet side of the reaction tube 1, an exhaust tube 6, a gate valve 7 and a vacuum pump 8.

The flow rate control system 3 comprises a plurality of mass-flow controllers 4.

Next, operation of the conventional chemical vapor growth apparatus having the above construction is explained.

In this case, a dichlorosilane (SiH₂Cl₂) gas and an ammonia (NH₃) gas are used as a source gas, and a nitrogen (N₂) gas is used as a purge gas.

In tubes except the reaction tube 1, for example, in a dichlorosilane gas supplying tube 9, a main gas line 10, a vacuum vent line 11, an air vent line 12 and a N2 gas supply tube 13, when the dichlorosilane gas and the ammonia gas are mixed each other, particles of powdery ammonium chloride are generated. Moreover, these particles attach to the inner walls of these tubes. The tubes are so clogged with these particles that the chemical vapor growth apparatus can not work at all.

To avoid this problem in the prior art, after the reaction process is finished, the dichlorosilane gas is exhausted by using the N₂ gas supply tube 13 and the vacuum vent line 11, and then the ammonia gas is purged by the combination of the N₂ gas supply tube 13 and the vacuum vent line 11 a little after the purge process of dichlorosilane gas.

However, by this method, the source gas remaining in the mass-flow controllers 4 can not be removed sufficiently.

Moreover, when other organic gases are used as the reaction gases, since it becomes necessary to provide large-scale heating means for heating the pipeline to prevent moisture condensation, the operation of the chemical vapor growth apparatus becomes complicated so much. In this case, the purge of gases remaining in the mass-flow controllers 4 becomes further difficult.

In such a manner, when the remaining gas is not sufficiently purged, the particles as mentioned above are generated in the lines 10, 11, and 12 and the vacuum pump 8 respectively communicated with the mass-flow controllers 4. Accordingly, to avoid the generation of particles in the lines, a large-scale heating system must be required.

Therefore, it is an object of the present invention to provide a chemical vapor growth apparatus being so constructed as to remove the source gas remaining in the flow rate control system with high efficiency.

According to the present invention, this object is solved by a chemical vapor growth apparatus having the features of claim 1.

The present invention has the advantage that that reaction products such as chloride particles are absorbed in the trap and do not attach to the internal walls of the gas flow rate control means and the vacuum pump.

Further improvements are specified in claims 2 to 4.

Preferred embodiments of the invention are described hereinafter with reference to Figs. 2 to 4 of the drawings.

In the drawings,
Fig.1 is a constructional diagram of a conventional chemical vapor growth apparatus,
Fig.2 is a partial constructional diagram of a chemical vapor growth apparatus which is an embodiment of the present invention,
Fig.3 is a partial constructional diagram of a chemical vapor growth apparatus which is another embodiment of the present invention, and
Fig.4 is a partial constructional diagram of a chemical vapor growth apparatus which is still another embodiment of the present invention.

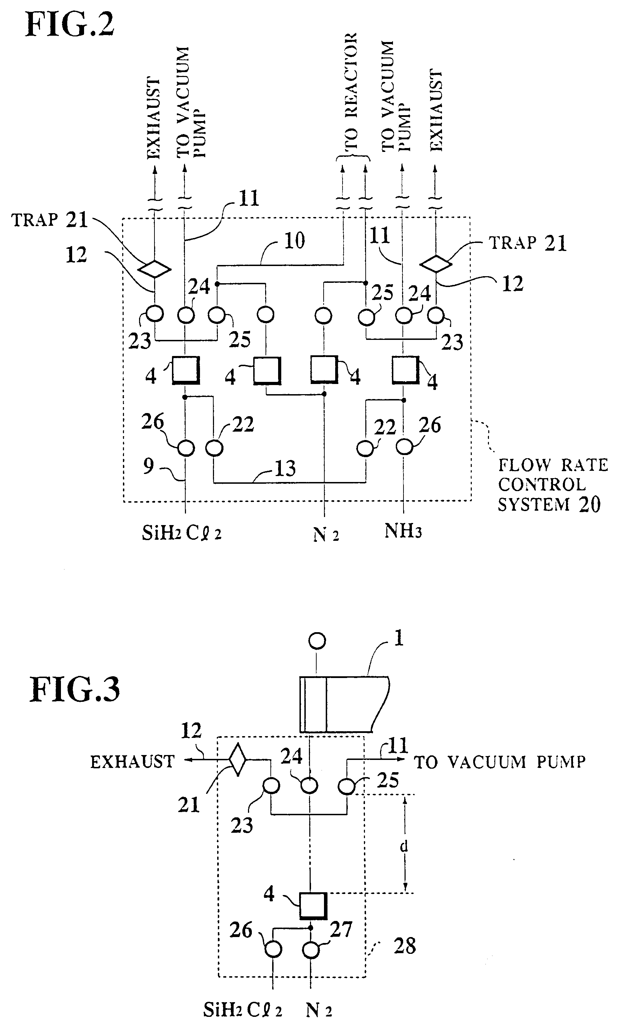

Fig.2 is a partial constructional diagram of a chemical vapor growth apparatus which is an embodiment of the present invention, and mainly shows gas flow rate control means, that is, a flow rate control system 20.

Incidentally, in the same diagram, the same constructional elements as those described in the conventional example as shown in Fig.1 are designated by the same reference numerals.

In Fig. 2, reference numeral 20 designates the flow rate control system having a plurality of mass-flow controllers 4. Moreover, reference numeral 21 designates each gas process means, for example, a trap having an absorbent corresponding to kinds of gases to be used. Each trap 21 is provided at exhaust means, that is, a portion of each of air vent lines 12. Except these parts, the other construction elements of the chemical vapor growth apparatus according to the present invention are the same as those in the conventional apparatus.

Hereinafter, operation of the chemical vapor growth apparatus of the embodiment having the above construction will be explained

First, valves 22 and 23 are opened, and valves 24, 25 and 26 are closed.

Then, the interior of the mass-flow controllers 4 are purged with a N₂ gas.

Thereafter, the valves 22, 23, 25 and 26 are closed, at the same time, the valves 24 are opened, so as to remove a remaining gas through vacuum vent lines 11.

After the process, the valves 24 are closed, then the valves 25 and 26 are opened to supply source gases, for example a dichlorosilane (SiH₂Cl₂), in the mass-flow controllers 4. At the time, the gas flow rate is controlled by the mass-flow controllers 4, and a reaction tube (not shown) is heated under reduced pressure by a heater element (not shown). As the result, a chemical vapor growth process is carried out in the reaction tube 1.

After the chemical vapor growth process, the valves 22 and 23 are opened, and 24, 25 and 26 are closed to introduce the N₂ gas in the pipeline to purge the source gas. At the time, the source gas is absorbed in the traps 21 by the absorbent provided therein. Thereafter, the valves 23 are closed and the valves 24 are opened so as to carry out the gas purge by the vacuum vent lines 11. At the time, since the source gas is removed by the absorption in the trap 21, the pipeline is filled with the N₂ gas.

As stated above, since the flow rate control system 20 in the chemical vapor growth apparatus of this embodiment comprises the traps 21, the source gas does not flow into a vacuum pump (not shown) through the vacuum vent lines 11 or remains in the mass-flow controllers as in the conventional apparatus.

Accordingly, it can be avoided that the source gases remaining in the pipeline, for example a dichlorosilane gas and an ammonia gas, are mixed therein, and particles of powdery ammonium chloride are produced, so that the pipeline is stopped by attachment of the particles to the inner walls. As the result, accumulation of the chloride particles on the inner walls of the flow rate control system and the vacuum pump can be prevented.

Fig.3 is a partial construction diagram of a chemical vapor growth apparatus which is another embodiment of the present invention.

In a flow rate control system 28 of this embodiment, a trap 21 is provided near to a reaction tube 1 as compared with the conventional apparatus by extending a piping distance "d" from an outlet of a mass-flow controller 4 to valves 23, 24, and 25. Moreover, by shortening the distance from the valves 23, 24 and 25 to the reaction tube 1, gas purge by using a N₂ gas can be carried out at any time under vacuum through a vacuum vent line 11. Accordingly, the purge efficiency of the mass-flow rate controller 4 and the flow rate control system 28 can be further improved.

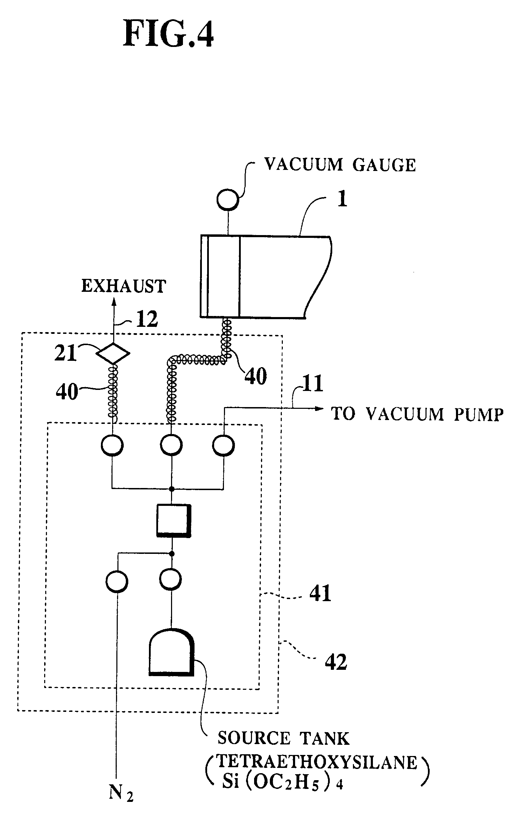

Fig.4 shows a still another embodiment in which the present invention is applied to a chemical vapor growth apparatus using an organic type source gas for instance, a tetraethoxysilane Si(OC₂H₅)₄ gas. As explained in the conventional apparatus, when the tetraethoxysilane (Si(OC₂H₅)₄) gas as the source gas of organic series is used, it is necessary to provide a heating system 40 and a constant-temperature chamber 41 to prevent the moisture condensation. The source gas of organic series is likely to generate reaction products so that the attachment of reaction products to a vacuum pump (not shown) and an air vent line 12 is likely to be caused as compared with inorganic gases. Particularly, when the products attach to the vacuum pump, the life-span of the pump is reduced.

In a flow rate control system 42 of this embodiment, as described in the embodiments of Figs.2 and 3, a trap 21 is provided in the course of the air vent line 12. As the result, the heating system to be provided in the vacuum vent line 11 becomes unnecessary, so that the construction of the chemical vapor growth system becomes simple so much.

Incidentally, in these embodiments, though the gas purge is explained with respect to the case after the reaction formation process in the reaction tube 1, this invention is not limited thereto, and it is possible to apply this invention to a process in which the flow rate control of a source gas is carried out by mass flow controller without flowing it into the reaction tube. In this case, it is also possible to remove the source gas of a high concentration by a trap.

Various modification will become possible for those skilled in the art after receiving the teachings of the present disclosure without departing from the scope thereof.

## Claims

1. A chemical vapor growth apparatus, comprising
(a) a process chamber (1) for carrying out a chemical vapor growth process;
(b) gas flow rate control means (20; 28; 41) for mainly supplying gases to the process chamber (1) in predetermined amounts;
(c) exhaust means incorporating an air vent line (12), for exhausting the gases remaining in the gas flow rate control means (20; 28; 41) and provided at a portion thereof; and
(d) gas process means formed by a trap (21) which is arranged at a portion of said exhaust means, for removing the gases.

2. The chemical vapor growth apparatus as claimed in claim 1, wherein said trap (21) includes an absorbent for absorbing the gases.

3. The chemical vapor growth apparatus as claimed in claim 1 or 2, wherein said trap (21) is provided near to the process chamber (1).

4. The chemical vapor growth apparatus as claimed in anyone of the preceding claims, wherein a heating system (40) is provided for the air vent line (12) leading to said trap (21).

## Patentansprüche

1. Einrichtung zur chemischen Dampfphasenabscheidung umfassend:
(a) eine Prozeßkammer (1) zur Durchführung des chemischen Dampfphasenabscheidungsprozesses;
(b) eine Gasdurchflußraten-Steuerungseinrichtung (20; 28; 41) für die hauptsächlich der Prozeßkammer (1) in vorbestimmten Anteilen zuzuführenden Gase;
(c) Absaugeinrichtungen, die eine Entlüftungsleitung (12) enthalten, um in der Gasdurchflußraten-Steuerungseinrichtung (20; 28; 41) zurückgebliebene Gase abzusaugen und die auf Teilen derselben vorgesehen sind und
(d) von einer Falle (21) gebildete Gasbehandlungseinrichtungen, die auf Teilen der Absaugeinrichtungen angeordnet sind, um die Gase zu entfernen.

2. Einrichtung zur chemischen Dampfphasenabscheidung nach Anspruch 1, bei der die Falle (21) ein Absorptionsmittel zur Absorption von Gasen enthält.

3. Einrichtung zur chemischen Dampfphasenabscheidung nach Anspruch 1 oder 2, bei der die Falle (21) nahe an der Prozeßkammer angebracht ist.

4. Einrichtung zur chemischen Dampfphasenabscheidung nach einem der vorhergehenden Ansprüche, bei der für die zur Falle (21) führenden Entlüftungsleitung (12) ein Heizsystem (40) angebracht ist.

## Revendications

1. Dispositif de croissance en phase gazeuse par procédé chimique, comprenant :
(a) une chambre de traitement (1) pour exécuter un processus de croissance en phase gazeuse par procédé chimique;
(b) un moyen de commande de débit de gaz (20; 28; 41) pour fournir principalement des gaz à la chambre de traitement (1) dans des quantités prédéterminées;
(c) un moyen d'échappement incorporant une conduite de ventilation d'air (12), pour évacuer les gaz restant dans le moyen de commande de débit de gaz (20; 28; 41), prévu à une partie de celui-ci; et
(d) un moyen de traitement de gaz constitué d'un piège (21) qui est disposé à une partie dudit moyen d'échappement, afin d'éliminer les gaz.

2. Dispositif de croissance en phase gazeuse par procédé chimique selon la revendication 1, dans lequel ledit piège (21) comprend un agent d'absorption afin d'absorber les gaz.

3. Dispositif de croissance en phase gazeuse par procédé chimique selon la revendication 1 ou 2, dans lequel ledit piège (21) est prévu à proximité de la chambre de traitement (1).

4. Dispositif de croissance en phase gazeuse par procédé chimique selon l'une quelconque des revendications précédentes, dans lequel un système de chauffage (40) est prévu pour la conduite de ventilation d'air (12) conduisant audit piège (21).
